Europäisches Patentamt

European Patent Office

Office européen des brevets

(19)

(11) Veröffentlichungsnummer: **0 302 383**
A1

(12) **EUROPÄISCHE PATENTANMELDUNG**

(21) Anmeldenummer: 88112147.9

(22) Anmeldetag: 27.07.88

(51) Int. Cl.4: **H01L 21/60 , H01L 21/90 , H01L 21/265**

(30) Priorität: 05.08.87 DE 3725994

(43) Veröffentlichungstag der Anmeldung:
08.02.89 Patentblatt 89/06

(84) Benannte Vertragsstaaten:
AT BE DE FR GB IT NL

(71) Anmelder: Siemens Aktiengesellschaft Berlin
und München
Wittelsbacherplatz 2
D-8000 München 2(DE)

(72) Erfinder: Küsters, Karl-Heinz, Dr.
Heinrich-Wieland-Strasse 71
D-8000 München 83(DE)
Erfinder: Sesselmann, Wolfgang, Dr.
Landwehrstrasse 70
D-8000 München 2(DE)

(54) Verfahren zum Herstellen von Kontakten mit niedrigem spezifischen Kontaktwiderstand auf integrierte Halbleiterschaltungen enthaltenden Substraten.

(57) Der niedrige spezifische Kontaktwiderstand eines, vorzugsweise aus dotiertem polykristallinem Silizium bestehenden Kontaktes (16, 26) auf eine, vorzugsweise aus einkristallinem Silizium (21, 22) bestehenden Oberfläche (15) wird nach der Lehre der Erfindung dadurch erhalten, daß nach dem Aufbringen der Kontaktmaterialschicht (16) Silizium-Ionen (17) in die Grenzfläche (15) : Polysilizium (16)-/Silizium (21, 22) implantiert werden und anschließend eine Temperbehandlung durchgeführt wird, mit der gleichzeitig die implantierten Dotierstoffionen (19a, 19b) aktiviert werden. Durch die Implantation der Silizium-Ionen (17) wird die Oxidschicht an der Grenzfläche (15) aufgebrochen und niedrige stabile Kontaktwiderstände erhalten. Das Verfahren wird verwendet bei der Herstellung von Kontakten, insbesondere sogenannten buried contacten in komplementären MOS-Transistorschaltungen.

FIG 4

## Verfahren zum Herstellen von Kontakten mit niedrigem spezifischen Kontaktwiderstand auf integrierte Halbleiterschaltungen enthaltenden Substraten.

Die Erfindung betrifft ein Verfahren zum Herstellen von als Elektroden-Anschlüsse oder elektrisch leitende Verbindungen zu verwendende Kontakte mit niedrigem spezifischen Kontaktwiderstand ($rho_c$) auf integrierte Halbleiterschaltungen enthaltenden Substraten.

Durch die zunehmende Integration und Packungsdichte in integrierten Schaltungen der Mikroelektronik werden Minimalabmessungen im $sub\mu m$-Bereich notwendig. Damit ergeben sich auch zunehmend kleinere Flächen für elektrisch leitende Kontakte und es ist zu erwarten, daß Kontaktwiderstände eine entscheidene Rolle für die Funktionsfähigkeit hochintegrierter Halbleiterschaltungen spielen werden, denn niederohmige Kontakte sind entscheidend für integrierte Schaltungen hoher Geschwindigkeit.

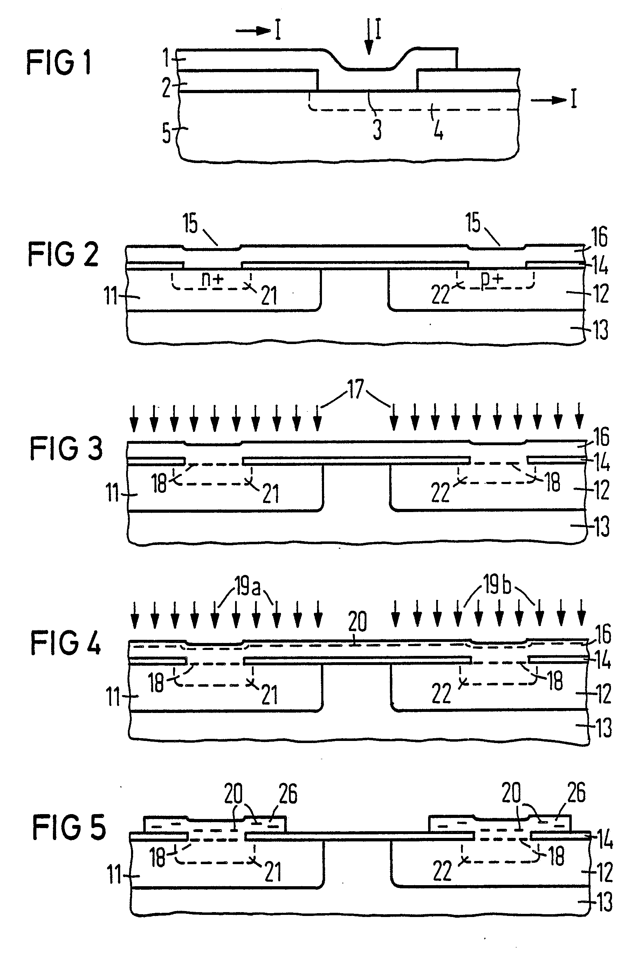

Der spezifische Kontaktwiderstand $rho_c$ ist definiert als proportional zum Potentialabfall an der Grenzfläche des Kontaktes, durch die der eingeprägte Strom I fließt. $rho_c$ ist daher ein eindeutiges Kriterium für die Güte des Kontaktes, unabhängig von den geometrischen Dimensionen und der Parameter, bezüglich dessen die Technologie zur Kontaktherstellung optimiert werden muß. Nähere Einzelheiten sind aus der Figur 1 ersichtlich, welche das Schema eines Kontaktes darstellt. Dabei gelten folgende Bezugszeichen:

    1 = elektrisch leitende Schicht,
    2 = Isolatorschicht,
    3 = Grenzfläche des Kontaktes,
    4 = zu kontaktierender Bereich, zum Beispiel $n^+$-dotiertes Silizium,
    5 = Substrat, zum Beispiel p-dotiertes Silizium.

Die eingezeichneten Pfeile zeigen die Stromrichtung I an.

Wie aus einem Bericht von Gary L. Patton et. al. im IEEE Transactions on Electron Devices, Vol. ED-33, Nr. 11, November 1986, auf den Seiten 1754 bis 1768, insbesondere Seite 1754, zu entnehmen ist, ist es beim Herstellungsprozeß von Kontakten auf Silizium technologisch nicht zu vermeiden, daß sich auf der Kontaktfläche ein sogenanntes "natürliches Oxid" von etwa 1.5 nm Dicke in kürzester Zeit spontan bildet, wenn die Siliziumkristallscheiben der natürlichen Atmosphäre oder Wasser ausgesetzt sind. Auch wenn die Silizium-Kontaktflächen unmittelbar bevor die elektrisch leitende obere Kontaktschicht, die zum Beispiel aus dotiertem Polysilizium oder Metall bestehen kann, aufgebracht wird, durch eine kurze Überätzung in Flußsäure von Oxid befreit werden, kann die Bildung einer derartigen Oxidschicht an der Grenzfläche nicht verhindert werden. Dieses natürliche Oxid, eine nicht-stöchiometrische Kohlenstoff enthaltende $SiO_x$-Verbindung, führt beim Kontakt: Polysilizium (dotiert)/Silizium (Polysilizium oder Silizium-Einkristall) zu hohen spezifischen Kontaktwiderständen $rho_c$. Wenn zudem die Kontaktfläche aus hoch p- oder n-dotiertem Silizium bestehen, wie es zum Beispiel bei Source- und Drain-Gebieten von MOS-Transistoren der Fall ist, wird das Wachstum der "natürlichen Oxidschicht" noch verstärkt.

Polysilizium/Silizium-Kontakte, auch "buried contact" genannt, finden in weiten Bereichen der hochintegrierten Mikroelektronik Anwendung. Beispiele sind Polyzid-Kontakte, die stacked-Speicherzelle, der Polysilizium-Emitter-Kontakt - wie er beispielsweise in dem bereits zitierten Bericht von Patton beschrieben wird -, Kontakte zu Source- und Drain-Gebieten von MOS-Transistoren in logischen Schaltungen und Silizium-Kontakte in dreidimensional-integrierten Schaltkreisen.

Um niedrige Kontaktwiderstände zu erhalten, ist es notwendig, die Oxidschicht an der Grenzfläche aufzubrechen. Dies ist möglich durch hohe Dotierung der oberen Polysiliziumschicht (Dotierstoffkonzentration größer $10^{20}$ $cm^{-3}$) und ein Eintreiben des Dotierstoffes bei 900 °C länger als 3 Stunden, bei 950 °C etwa 1 Stunde oder höheren Temperaturen (siehe Bericht von Patton). Derartig hohe Temperaturbelastungen sind, wie aus einem Bericht von L. C. Parillo im IEDM Technical Digest 1985 auf den Seiten 398 bis 402 zu entnehmen ist, jedoch mit VLSI-Anwendungen nicht verträglich.

Eine weitere Möglichkeit, niedrige Kontaktwiderstände zu realisieren wäre, den Dotierstoff in ausreichend hoher Dosis und mit hoher kinetischer Energie in die Grenzfläche zu implantieren. Dadurch wird eine Amorphisierung der Grenzschicht erreicht und die Oxidschicht ebenfalls aufgebrochen. Ein solches Verfahren wird als "Ion mixing" bezeichnet und in einem Bericht von D. K. Brice im Journal of Applied Physics 46(1975) auf den Seiten 3385 bis 3394 beschrieben. Diese Vorgehensweise führt jedoch dazu, daß zusätzlich Dotierstoff in die Kontaktregion eingebracht wird. Dies wirkt sich nachteilig auf die in VLSI-Anwendungen notwendigen flachen Dotierstoffprofile aus und kann das Degradationsverhalten einzelner Schaltungselemente empfindlich verschlechtern, wenn die Dotierstoffverteilungen, wie zum Beispiel bei LDD-Transistoren ( = lightly doped drain-Transistoren), optimiert sind. Außerdem ist diese Technik nicht ohne weiteres für CMOS-Schaltungen anwendbar, da Gebiete mit komplementärer Dotierung bei dieser Vorgehensweise durch eine sehr widerstandsfähige Maske (Lack, Oxid oder ähnliches) abgedeckt werden müssen. Dazu ist unter anderem eine zusätzliche Phototechnik-Ebene erforderlich.

Die Aufgabe, die der Erfindung zugrundeliegt, besteht nun darin, ein Verfahren zur Herstellung von Kontakten mit niedrigen spezifischen Kontaktwiderständen anzugeben, welches für VLSI ( = very large scale integration)-Anwendungen geeignet ist und welches insbesondere CMOS-kompatible Polysilizium/Silizium-Kontakte mit niedrigem Kontaktwiderstand schafft.

Diese Aufgabe wird dadurch gelöst, daß nach dem Aufbringen des Kontaktmaterials auf die Oberfläche des zu kontaktierenden Bereiches der Schaltung eine Implantation mit dem Material des zu kontaktierenden Bereiches arteigenen Ionen und anschließend eine Temperbehandlung durchgeführt wird.

Dabei liegt es im Rahmen der Erfindung, daß unmittelbar nach der Implantation in die Kontaktmaterialschicht Dotierstoffionen mit einer gegenüber der normalen Dotierstoffimplantation niedrigeren Energie (typische Werte: 30 bis 50 keV) implantiert werden, die durch die Temperung mitaktiviert werden.

Gemäß einem Ausführungsbeispiel nach der Lehre der Erfindung werden zur Herstellung von dotierten Polysiliziumkontakten auf $n^+$-dotierten Siliziumoberflächen Silizium-Ionen in die Grenzschicht Polysilizium/Silizium implantiert, wobei bei einer Schichtdicke der Polysiliziumschicht im Bereich von ca. 100 nm die Energie und Dosis bei der Siliziumimplantation auf $1 \times 10^{15}$ cm$^{-2}$ und 70 keV und die der aus Arsen-, Antimon- oder Phosphor-Ionen bestehenden Dotierstoff-Implantation auf $2 \times 10^{16}$ cm$^{-2}$ und 40 keV eingestellt wird. Die Temperung erfolgt im Bereich von 950° C maximal 10 Minuten.

Der hier vorgeschlagene und automatisch CMOS-kompatible Prozeß beruht auf einer Silizium-Implantation in die Grenzfläche, wodurch die Oxidzwischenschicht im Kontaktlochbereich aufgebrochen wird. Der Dotierstoff (n- oder p-Dotierung) wird durch eine Implantation mit niedriger Energie nur in die äußersten Bereiche der oberen Polysiliziumschicht gebracht. Diese Polysiliziumschicht wird strukturiert und von allen Bereichen entfernt, auf denen sie nicht benötigt wird. Dadurch gelangt kein Dotierstoff in Gebiete komplementärer Dotierung und der Prozeß ist von sich aus CMOS-kompatibel und für p- und n-dotierte Kontakte verwendbar. Für die Implantationen werden keine Phototechnikmasken benötigt, wenn nur n-dotierte oder nur p-dotierte Kontakte hergestellt werden. (Die gleichzeitige Fertigung von n- und p-dotierten Kontakten wird im nachfolgenden Ausführungsbeispiel erläutert). Durch die anschließende kurze Temperung bei 950° C wächst die Polysiliziumschicht im Kontaktlochgebiet nahezu epitaktisch an, der Dotierstoff wird aktiviert und verteilt sich homogen in der Polysiliziumschicht. Dadurch entstehen Kontakte mit niedrigem spezifischen Kontaktwiderstand.

Weitere Einzelheiten und Vorteile der Erfindung werden nachfolgend anhand eines Ausführungsbeispiels und der Figuren 2 bis 6 noch näher erläutert. Dabei zeigen

die Figuren 2 bis 5 im Schnittbild die wesentlichen Verfahrensschritte in einem Prozeßablauf für einen n-dotierten Kontakt zu einem $n^+$-dotierten Diffusionsgebiet, und gleichzeitig einen p-dotierten Kontakt zu einem $p^+$-dotierten Diffusionsgebiet. Dies wäre die Vorgehensweise bei der Herstellung einer CMOS-Schaltung. Natürlich lassen sich auch entsprechend nur n-dotierte oder nur p.dotierte Kontakte herstellen.

Die Figur 6 zeigt in einem Diagramm den spezifischen Kontaktwiderstand $rho_c$ eines Polysilizium-Kontaktes in Abhängigkeit von der Arsen$^+$-Implantationsenergie.

Figur 2: Auf einem, mit p-dotierten und n-dotierten Gebieten 11, 12 (Wannen) versehenen Siliziumsubstrat 13 einer CMOS-Schaltung werden in der Isolatorschicht 14 ($SiO_2$) über dem $n^+$-dotierten Gebiet 21 und dem $p^+$-dotierten Gebiet 22 die Kontakte geöffnet (siehe Pfeile 15) und dann ganzflächig eine Polysiliziumschicht 16 aufgebracht.

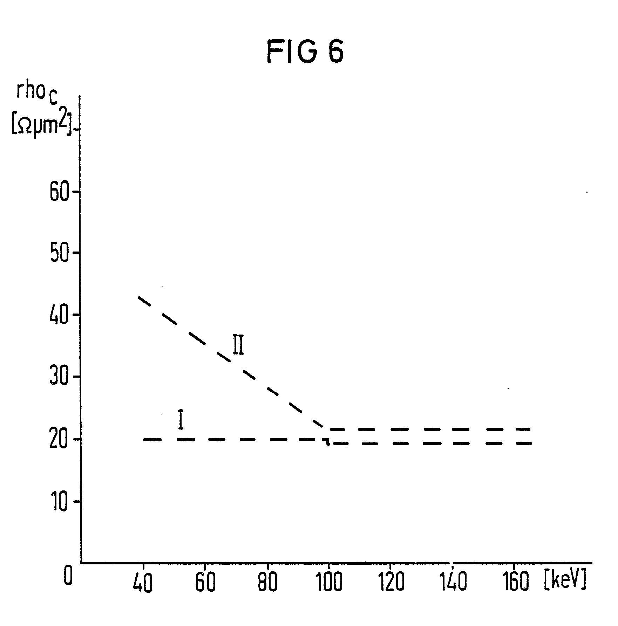

Figur 3: dann wird ganzflächig eine Si$^+$-Ionenimplantation (siehe parallel laufende Pfeile 17) mit einer Energie und Dosis von $1 \times 10^{15}$ cm$^{-2}$ und 70 keV durchgeführt, die bis zur Grenzschicht 18 im Kontaktloch (5) eindringt und das natürliche Oxid dort aufbricht.

Figur 4: Die Implantation des Dotierstoffes Arsen, Antimon oder Phosphor (siehe parallel laufende Pfeile 19a) erfolgt mit niedriger Energie, im Ausführungsbeispiel mit Arsen mit einer Dosis und Energie von $2 \times 10^{16}$ cm$^{-2}$ und 40 keV. Die implantierten Ionen sind durch die gestrichelte Linie 20 dargestellt. Entsprechend erfolgt die Implantation des Dotierstoffs (zum Beispiel Bor oder Bordifluorid) (siehe parallel laufende Pfeile 19b) für die p-dotierten Kontakte. Wird eine Dotierstoffimplantation (n oder p) mit so hoher Dosis durchgeführt, daß die komplementäre Implantation (p oder n) kompensiert wird, so genügt eine Photolackmaske für die Implantation mit hoher Dosis. Im anderen Fall werden die für CMOS-Implantation standardmäßigen zwei Photolackmasken verwendet.

Figur 5 zeigt die Anordnung nach der Strukturierung der dotierten Polysiliziumschicht 16 und nach der Temperung zur Aktivierung des Dotierstoffes (950° C, 8 Minuten lang). Die Polysiliziumstruktur 26 wächst dabei nahezu epitaktisch im Kontaktlochbereich (21 und 22) auf.

Der vorgeschlagene Prozeß für einen niederohmigen buried contact ist für CMOS-Schaltungen geeignet (n- und p-dotierte Kontakte). Dies ist eine Randbedingung, die von keiner der in der Beschreibungseinleitung beschriebenen und aus der Literatur bekannten Vorgehensweise erfüllt wird. Der Prozeß benötigt dazu keine zusätzliche Phototechnik-Maske; die Dosis zur Dotierung der Polysiliziumschicht (16) ist nicht direkt mit dem spezifischen Kontaktwiderstand gekoppelt, da der Dotierstoff nicht dazu benutzt wird, das Grenzflächenoxid aufzubrechen. Außerdem wird nur eine geringe Menge an zusätzlichem Dotierstoff in den Kontaktbereich eingebracht, wodurch flache pn-Übergänge und andere für die Funktion aktiver Bauelemente optimierte Dotierstoffverteilungen nicht beeinträchtigt werden. Die Temperaturbelastung kann sehr niedrig gehalten werden, da Dotierstoffe in Polysilizium sehr effektiv diffundieren. Für Arsen ist zum Beispiel das Verhältnis der Diffusionskoeffizienten D in Polysilizium und in Monosilizium bei $900\,^\circ$ C D(Poly Si)/D(Mono Si) = 800 : 1 und bei $950\,^\circ$ C D(Poly Si)/D(Mono Si) = 9000 : 1. Daher ist eine Temperung zur Aktivierung bei $950\,^\circ$ und kurzen Zeiten (kleiner 10 Minuten) einer längeren Temperung bei $900\,^\circ$ C wegen der relativ geringen Diffusion im Monosilizium (flache pn-Übergänge!) vorzuziehen.

Figur 6: Für eine 100 nm dicke Polysiliziumschicht ist in dem Kurvendiagramm gezeigt, daß der spezifische Kontaktwiderstand $rho_c$ für den vorgeschlagenen Prozeßablauf mit $1 \times 10^{15}$ cm$^{-2}$, 70 keV Si$^+$-Implantation (siehe Pfeile 17 in Figur 3) und einer flachen Arsen$^+$-Implantation mit $2 \times 10^{16}$ cm$^{-2}$, 40 keV (siehe Pfeile 19a in Figur 4) vergleichbare Werte (Kurve I) liefert zu dem Fall einer Arsen$^+$-Implantation hoher Energie (größer 100 keV) in die Polysilizium/Silizium-Grenzfläche. Ohne Silizium-Implantation (Kurve II) ergibt sich ein um mehr als doppelt so hoher $rho_c$-Wert. Die Widerstände zeigen in allen Fällen eine ohmsche Stromspannungscharakteristik. Die Eigenschaften der n$^+$-p-Dioden werden durch die Si$^+$-Implantation nicht beeinträchtigt.

Der Prozeß für einen buried contact mit niedrigem $rho_c$ ist nicht auf das Material Silizium beschränkt, sondern auch anwendbar bei anderen einkomponentigen und mehrkomponentigen elektrisch leitenden Materialien, wenn Atome dieser Grundmaterialien implantiert werden.

## Ansprüche

1. Verfahren zum Herstellen von als Elektroden-Anschlüsse oder elektrisch leitende Verbindungen zu verwendende Kontakte mit niedrigem spezifischen Kontaktwiderstand ($rho_c$) auf integrierte Halbleiterschaltungen enthaltenden Substraten, **dadurch gekennzeichnet,** daß nach dem Aufbringen des Kontaktmaterials (16) auf die Oberfläche (15) des zu kontaktierenden Bereiches (21, 22) der Schaltung eine Implantation (17) mit dem Material des zu kontaktierenden Bereiches (21, 22) arteigenen Ionen und anschließend eine Temperbehandlung durchgeführt wird.

2. Verfahren nach Anspruch 1, **dadurch gekennzeichnet,** daß unmittelbar nach der Implantation (17) in die Kontaktmaterialschicht (16) Dotierstoffionen (19a, 19b) mit einer gegenüber der normalen Dotierstoffimplantation niedrigeren Energie implantiert werden, die durch die Temperung (20) mitaktiviert werden.

3. Verfahren nach Anspruch 1 oder 2, **dadurch gekennzeichnet,** daß zur Herstellung von dotierten Polysiliziumkontakten (26) auf n$^+$-dotierten bzw. p$^+$-dotierten Siliziumoberflächen (21, 22) Silizium-Ionen (17) in die Grenzschicht Polysilizium/Silizium (15) implantiert werden, wobei bei einer Schichtdicke der Polysiliziumschicht (16) im Bereich von ca. 100 nm die Energie und Dosis bei der Siliziumimplantation (17) auf $1 \times 10^{15}$ cm$^{-2}$ und 70 keV und die der aus Arsen, Antimon oder Phosphor-Ionen bzw. Bor-Ionen bestehenden Dotierstoff-Implantation (19a, 19b) auf $2 \times 10^{16}$ cm$^{-2}$ und 40 keV eingestellt wird.

4. Verfahren nach einem der Ansprüche 1 bis 3, **dadurch gekennzeichnet,** daß die Temperung im Bereich von $950\,^\circ$ C maximal 10 Minuten durchgeführt wird.

5. Verwendung des Verfahrens nach den Ansprüchen 1 bis 4 zur Herstellung von n-dotierten und/oder p-dotierten sogenannten buried contacts (= Polysiliziumkontakte) in CMOS-Schaltungen.

FIG 1

FIG 2

FIG 3

FIG 4

FIG 5

## FIG 6

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| X | US-A-4 663 825   (MAEDA) <br> * Insgesamt * | 1 | H 01 L 21/60 <br> H 01 L 21/90 <br> H 01 L 21/265 |
| A | --- | 4,5 | |
| A | GB-A-2 185 624   (MOTOROLA INC.) <br> * Seite 4, Zeilen 25-33 * <br> ----- | 3 | |

|  |  |
|---|---|
|  | **RECHERCHIERTE SACHGEBIETE (Int. Cl.4)** |
|  | H 01 L |

Der vorliegende Recherchenbericht wurde für alle Patentansprüche erstellt

| Recherchenort | Abschlußdatum der Recherche | Prüfer |
|---|---|---|
| DEN HAAG | 14-11-1988 | PHEASANT N.J. |